# EUROPEAN PATENT APPLICATION

(11) **EP 4 718 730 A1**
(43) Date of publication of application: **01.04.2026**
(21) Application number: 24202467.7
(22) Date of filing: 25.09.2024
(51) Int. Cl.: H03L 7/087, H03L 7/089

(54) **AN APPARATUS COMPRISING A PHASE LOCKED LOOP**

(71) Applicant: NXP B.V., 5656 AG Eindhoven (NL)
(72) Inventor: Derksen,, Sander, 5656 AG Eindhoven (NL); Verlinden,, Jos, 5656 AG Eindhoven (NL); Smolenaers,, Paul, 5656 AG Eindhoven (NL)
(74) Representative: Schmütz, Christian Klaus Johannes

(57) **Abstract**

An apparatus comprising a phase locked loop circuit including: an input configured to receive an oscillating reference signal having a reference period; a current-controlled-oscillator, CCO, configured to generate an oscillating output signal based on an input signal; an error detector configured to generate one or more error signals based on a phase difference between the reference signal and one or more feedback signals wherein the feedback signals are based on the oscillating output signal; and a charge pump circuit configured to receive at least a first of the error signals, determine a voltage indicative of a duration of the first error signal during a first part of the reference period, and provide a control current to the CCO for at least a remaining part of the reference period, wherein the control current comprises at least part of the input signal to the CCO and is based on the determined voltage.

## Description

### Field

The present disclosure relates to an apparatus comprising a phase locked loop circuit. In particular, it relates to an apparatus comprising a phase locked loop circuit that includes a charge pump circuit for reducing signal spurs in an output of the phase locked loop circuit.

### Background

A phase lock loop, PLL, is a circuit that generates an output signal whose phase and frequency is based on the phase of an input signal. Provision of a PLL with improved signal performance remains a challenge.

### Summary

According to a first aspect of the present disclosure there is provided an apparatus comprising:
a phase locked loop circuit including:
   an input configured to receive an oscillating reference signal having a reference period;
   a current controlled oscillator, CCO, configured to generate an oscillating output signal based on an input signal;
   an error detector configured to generate one or more error signals based on a phase difference between the reference signal and at least one of one or more feedback signals wherein the one or more feedback signals are based on the oscillating output signal; and
a charge pump circuit configured to receive at least a first of the one or more error signals, determine a voltage indicative of a duration of the first error signal during a first part of the reference period, and provide a control current to the CCO for at least a remaining part of the reference period, wherein the control current comprises at least part of the input signal to the CCO and is based on the determined voltage.

In one or more embodiments the error detector may be a phase frequency detector comprising:
a first, proportional part configured to generate the first error signal of the one or more error signals based on the difference between the reference signal and a first feedback signal of the one or more feedback signals that is based on the oscillating output signal.

In one or more embodiments the phase frequency detector also comprises:
a second, integrating part configured to generate a second error signal of the one or more error signals based on an integration of the difference between the reference signal and a second feedback signal of the one or more feedback signals that is based on the oscillating output signal.

In one or more embodiments the charge pump circuit comprises a first charge pump circuit and the control current comprises a first control current and thereby the first charge pump circuit is configured to receive the first error signal, determine the voltage indicative of the duration of the first error signal during the first part of the reference period, and provide the first control current to the CCO comprising at least part of the input signal based on the determined voltage for at least the remaining part of the reference period.

In one or more embodiments, the charge pump circuit further includes:
a second charge pump circuit configured to generate a control signal based on the second error signal; and
a current source configured to generate a second control current based on the control signal.

In one or more embodiments the input signal to the CCO is based on the first control current and the second control current.

In one or more embodiments the charge pump circuit comprises a time-to-voltage circuit configured to convert at least one of the one or more error signals representing the phase difference between the reference signal and the one or more feedback signals to a voltage signal.

In one or more embodiments the charge pump circuit also comprises a voltage-to-current circuit configured to receive the voltage signal from the time-to-voltage circuit and convert it to the control current.

In one or more embodiments the first charge pump circuit comprises a time-to-voltage circuit configured to convert the first error signal to a voltage signal; and a voltage-to-current circuit configured to receive the voltage signal from the time-to-voltage circuit and convert it to the control current.

In one or more embodiments:
the time-to-voltage circuit includes a first capacitor and the time-to-voltage circuit is configured such that the first capacitor is charged by a current induced by a source voltage while the first error signal is provided to the time-to-voltage circuit.

In one or more embodiments:
the time-to-voltage circuit includes a second capacitor and wherein said charge pump circuit is configured to sample the error signal during the first part of the reference period by the time-to-voltage circuit being configured to couple the first capacitor to the second capacitor such that that the second capacitor is charged by the first capacitor and a voltage over the second capacitor defines the voltage signal.

In one or more embodiments:
the voltage-to-current circuit comprises a voltage follower configured to receive the voltage signal from the second capacitor and, based on the voltage signal, control a voltage applied to an impedance circuit.

In one or more embodiments:
the impedance circuit comprises a switched capacitor circuit comprising a third capacitor that is switched at the frequency of the oscillating output signal.

In one or more embodiments:
the control current is based on a voltage over the impedance circuit.

In one or more embodiments the first capacitor and the third capacitor are of the same type, and the ratio of the capacitance between the first capacitor and the third capacitor is programmable.

In one or more embodiments the voltage follower comprises a first amplifier and a first transistor.

In one or more embodiments:
an output of the first amplifier may be coupled to a gate of the first transistor,
a non-inverting input of the first amplifier may be coupled to the second capacitor,
an inverting input of the first amplifier may be coupled to a source terminal of the first transistor,
the source terminal of the first transistor may be coupled to a first terminal of the impedance circuit,
a second terminal of the impedance circuit may be configured to be coupled to a reference voltage, and
a drain terminal of the first transistor may be coupled to receive part of the second control current.

In one or more embodiments the current source comprises a second transistor having a source terminal configured to be coupled to a voltage source, a gate terminal configured to receive the control signal based on the second error signal and a drain terminal configured to provide the second control current for control of the CCO.

In one or more embodiments the source terminal of the second transistor is also coupled to a first terminal of a fourth capacitor, and the gate terminal of the second transistor is also coupled to a second terminal of the fourth capacitor.

In one or more embodiments the time-to-voltage circuit is configured to be coupled to the voltage source via a third transistor having a source terminal configured to be coupled to the voltage source, a gate terminal configured to receive the control signal based on the second error signal and a drain terminal configured to provide a supply current to the first capacitor.

In one or more embodiments the source terminal of the third transistor is also coupled to the first terminal of the fourth capacitor, and the gate terminal of the second transistor is also coupled to the second terminal of the fourth capacitor.

In one or more embodiments, the apparatus further includes a controller configured to advance the provision of the first feedback signal to the first, proportional part relative to the provision of the second feedback signal to the second, integrating part.

In one or more embodiments the advancement is based on a predetermined number of oscillations of the oscillating output signal.

In one or more embodiments the apparatus further includes a controller configured to generate a reset signal to short the first capacitor prior to the controller being configured to generate a sample signal.

In one or more embodiments the first charge pump circuit, based on receipt of the sample signal, is configured to sample the determined voltage during the first part of the reference period.

In one or more embodiments the apparatus is configured to provide a constant current to the time-to-voltage circuit.

In one or more embodiments the input signal to the CCO is based on the second control current minus the first control current.

In one or more embodiments the apparatus further comprises an additional proportional charge pump, configured to supply a third control current to the CCO, wherein the third control current is constant.

According to a second aspect of the present disclosure there is provided an electronic device comprising the apparatus of the first aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example apparatus according to an embodiment of the present disclosure; and
Figure 2 shows a signal diagram representing a number of signals within the example apparatus.

### Detailed Description

Phase-locked loop circuits may suffer from reference clock feedthrough which manifests as spurs. The spurs may be due to a phase error at the input of an error detector which is part of the PLL. The spurs can limit the phase noise performance of the PLL. The phase error may have different root causes such as mismatch or leakage, but in some cases phase error can also be caused intentionally, for example for linearization in fractional PLLs. It is possible to reduce the reference clock feedthrough by filtering, but further improvement is desirable.

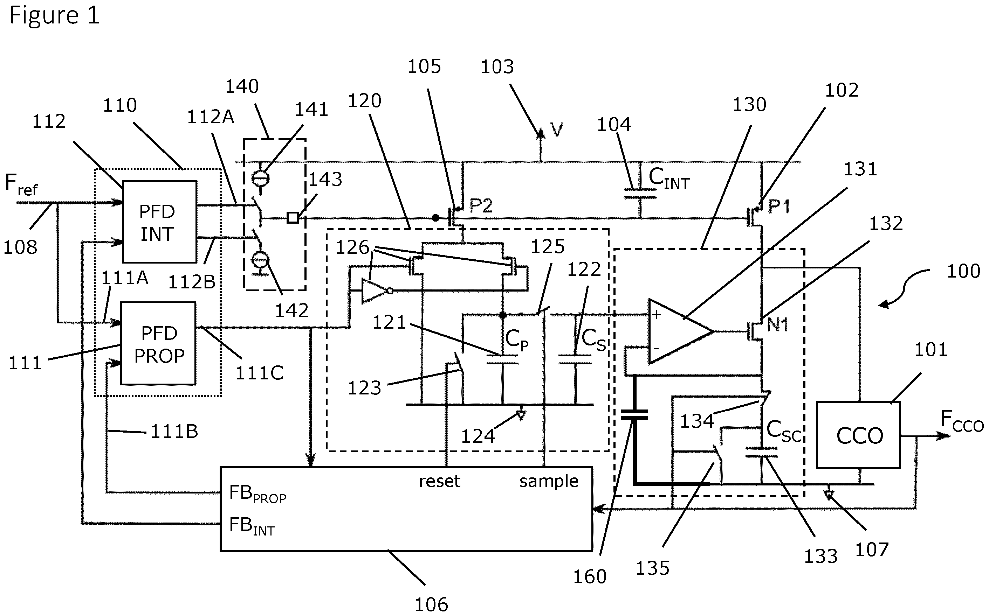

Figure 1 shows an example apparatus according to an embodiment of the present disclosure. The apparatus comprises a PLL circuit 100 including an input 108 configured to receive an oscillating reference signal F_{ref} having a reference period. The PLL circuit 100 further comprises a current controlled oscillator CCO 101 configured to generate an oscillating output signal F_{CCO} based on an input signal provided thereto by other components of the PLL circuit 100 described later. The PLL circuit 100 also includes an error detector 110 which is configured to generate one or more error signals based on a phase difference between the reference signal F_{ref}, provided at a first input terminal 111A, and at least one of one or more feedback signals, such as feedback signal FB_{PROP} provided at a second input terminal 111B. In this embodiment, the error detector 110 is a phase frequency detector and will be referred to as such throughout the rest of the disclosure for ease of understanding. It will be appreciated however, that other error detectors may be used instead, for example a sub-sampler.

The one or more feedback signals are based on the oscillating output signal F_{CCO}. For example, the one or more feedback signals may comprise the oscillating output signal F_{CCO} or a frequency divided (or multiplied) version of the oscillating output signal F_{CCO}, or a filtered version of the oscillating output signal F_{CCO}. The one or more feedback signals may also be phase shifted with respect to the oscillating output signal F_{CCO}. The apparatus 100 also includes a charge pump circuit 120, 130, 140 configured to receive at least one of the one or more error signals, and sample a source voltage based on the error signal during a first part of the reference period. In some embodiments, the first part of the reference period is an initial part of the reference period. In other embodiments, the first part of the reference period is a different part of the reference period, such as a final part of the reference period. Accordingly, the voltage is indicative of the duration of the error signal. The charge pump circuit is further configured to provide a control current to the CCO 101 for at least a remaining part of the reference period. In some examples, the control current is provided to the CCO 101 until a new value is available. That is, until the source voltage is sampled again. The control current, that is based on the sampled source voltage, comprises the input signal to the CCO 101 or at least part of the input signal to the CCO 101.

In this example embodiment, the PLL circuit 100 comprises a type II dual charge pump PLL and the oscillator of the PLL is the CCO 101. However, it will be appreciated that any suitable alternative PLL circuit configuration may be used, such as a PLL circuit 100 comprising a type I charge pump. Here, the term "a *type II dual charge pump PLL"* refers to one which has two separate charge pumps 120, 130 and 140and wherein the phase frequency detector 110 comprises proportional and integrating parts. As will be understood by those skilled in the art, the proportional part determines the instantaneous difference between the reference signal and the one or more feedback signals, and the integrating part determines an integral or time-average which is based on the difference between the reference signal and the one or more feedback signals over a time period.

In this example embodiment, the first, proportional part 111 is configured to generate a first error signal at output terminal 111C based on the difference between the reference signal F_{ref} and a first feedback signal, FB_{PROP} that is based on the oscillating output signal F_{CCO}. The second, integrating part 112 is configured to generate a second error signal of the one or more error signals based on an integration of the difference between the reference signal F_{ref} and a second feedback signal FB_{INT}. The second feedback signal is based on the oscillating output signal F_{CCO}. In the present example, the second error signal comprises a first component or "down" signal and a second component or "up" signal provided at outputs 112A and 112B respectively, as will be appreciated by those skilled in the art. The first error signal and the second error signal are provided for controlling the charge pump circuit.

In this embodiment, the oscillating output signal F_{cco} is divided down by a controller 106 to produce the second feedback signal FB_{INT}, but any other suitable method for generating the second feedback signal FB_{INT} may be used. In an alternative embodiment, the PLL circuit 100 may comprise a type I PLL, which simply applies a bias current instead of using the integrating part 112 of the phase frequency detector 110. Any other suitable phase frequency detectors may be used, such as a sub-sampled digital phase frequency detector.

In some embodiments, the charge pump circuit 120, 130 comprises a time-to-voltage circuit 120 connected to a voltage-to-current circuit 130 for conversion of the error signal to a current applied to the CCO. In the present example, the time-to-voltage circuit 120 is configured to convert at least one of the one or more error signals representing the phase difference between the reference signal F_{ref} and the one or more feedback signals, FB_{PROP}, to a voltage signal. The voltage-to-current circuit 130 is configured to receive the voltage signal from the time-to-voltage circuit 120 and convert it to the control current for the CCO 101.

However, in the present example embodiment, the charge pump circuit includes a first charge pump circuit (provided by the time-to-voltage circuit 120 and the voltage-to-current circuit 130), which outputs a first control current. Thus, it is the first charge pump circuit 120, 130 that is configured to receive the first error signal PROP_{dn}, sample the first error signal during the first part of the reference period, and provide the first control current to the CCO 101 for at least the remaining part of the reference period.

Further, in the present example embodiment, the apparatus includes a second charge pump circuit 140 provided by switched current sources 141, 142 controlled by the component signals of the second error signal. The second charge pump circuit 140 is configured to generate a second charge pump current which is used to generate a second control current for control of the CCO based on the second error signal INTᵤₚ, INT_{dn}, as will be discussed below. Thus, in the present example, the input signal to the CCO 101 is based on the first control current and the second control current.

The present embodiment shows the first charge pump circuit controlled by a first error signal PROP_{dn} comprising a single "down" pulse component output, as will be appreciated by those skilled in the art. Thus, the proportional part 111 of the phase frequency detector 110 is a standard PFD wherein only the down output is utilized. In other embodiments the first charge pump circuit may be configured to be controlled by only "up" pulses, or both up and down pulses.

The time-to-voltage circuit 120 includes a first capacitor 121 and the time-to-voltage circuit 120 is configured such that the first capacitor 121 is charged to a voltage based on the first error signal PROP_{dn}. The time-to-voltage circuit also includes a second capacitor 122. The charge pump circuit samples the error signal during the first part of the reference period by the time-to-voltage circuit 120 being configured to couple the first capacitor 121 to the second capacitor 122 such that that the second capacitor 122 is charged by the first capacitor 121. It will be appreciated that other suitable methods to convert the phase error time into a voltage may be used and other sampling methods may also be used. In this embodiment, the voltage-to-current circuit 130 comprises a voltage follower 131, 132 configured to receive the voltage of the second capacitor 122 and, based on the voltage of the second capacitor 122, control the voltage applied to an impedance circuit which is formed by a third capacitor 133 and a pair of oscillation switches 134, 135. A current is provided to the impedance circuit by a second transistor, which is discussed below. The oscillation switches 134, 135 are switched by the oscillating output signal F_{CCO}. The first control current is provided by the voltage over the third capacitor 133. Advantageously, because the third capacitor 133 is switched at the oscillating output signal frequency F_{CCO}, no spurs are generated by the voltage-to-current circuit 130. The use of the third capacitor 133 also allows the bandwidth to be first order independent of processing, supply voltage and temperature (PVT). Alternatively, a standard resistor could be used in place of the impedance circuit 133, 134, 135. Using a resistor would not consume any power from clocking, but it would lose the advantage of PVT independence when compared with the impedance circuit 133, 134, 135 shown in Figure 1.

In some embodiments, the first capacitor 121 and the third capacitor 133 are the same type. Therefore, the first capacitor 121 and that third capacitor 133 respond in the same way to any changes in circuit conditions. Advantageously, this means that the oscillator control current is relative to the main oscillator current and further only dependent on the time error (the main function), so the bandwidth becomes almost PVT independent. This is because the current provided by a second transistor 102 (which provides current to the CCO 101, as discussed below) and the current provided by the third transistor 105 (which provides current to the first capacitor) are the same, or are provided according to a ratio, and are dependent on the frequency of the oscillating output signal F_{CCO}. Additionally, it has been found that an intentional offset between the reference frequency and the oscillating output frequency does not result in the generation of spurs. This is useful for linearization purposes. The ratio of capacitance between the first capacitor 121 and the third capacitor 133 may be predetermined or programmable in order to achieve the desired bandwidth for the PLL circuit 100. In embodiments where the current provided by the second transistor 102 and the current provided by the third transistor 105 are provided according to a ratio, the ratio of currents may be predetermined or programmable in order to achieve the desired bandwidth for the PLL circuit 100. The ratio of capacitance and the ratio of current may be the same or different.

In the embodiment shown in Figure 1, the voltage follower 131, 132 comprises a first amplifier 131 (e.g. an operational transconductance amplifier) and a first (e.g. NMOS) transistor 132, wherein an output of the first amplifier 131 is coupled to a gate of the first transistor 132, a non-inverting input of the first amplifier 131 is coupled to the second capacitor 122, an inverting input of the first amplifier 131 is coupled to a source terminal of the first transistor 132, the source terminal of the first transistor 132 is coupled to a first terminal of the impedance formed by the third capacitor 133 and the oscillating switches 134, 135. A second terminal of the third capacitor 133 is configured to be coupled to a reference voltage terminal 107, and a drain terminal of the first transistor 132 is coupled to receive part of the second control current. The reference voltage terminal 107 may be a ground terminal, or the reference voltage terminal 107 may be configured to provide a non-zero reference voltage. Although the first transistor 132 is described using language commonly associated with metal-oxide-semiconductor field-effect-transistors (MOSFETs), any other type of transistor may be used. This is also true for all of the other transistors described within this disclosure, also relevant circuit adjustments understood by those skilled in the art may be required.

In this embodiment, the second charge pump circuit 140 comprises a first current source 141 and a second current source 142, coupled in between a voltage source 103 and a reference voltage terminal. A second charge pump terminal 143 is connected between the first current source 141 and the second current source 142 and is configured to provide a control signal. A first switch is connected between the first current source 141 and the second charge pump terminal 143, and the first switch is controlled by the first component (the "down" signal) of the second error signal. A second switch is connected between the second current source 142 and the second charge pump terminal 143, and the second switch is controlled by the first component (the "up" signal) of the second error signal. As such, the second charge pump circuit 140 is configured to provide a control signal based on the second error signal INT_{dn}, INTᵤₚ at the second charge pump terminal 143.

In this embodiment, the PLL circuit 100 also includes a second transistor 102 having a source terminal configured to be coupled to the voltage source 103, a gate terminal configured to receive the control signal based on the second error signal INT_{dn}, INTᵤₚ, and a drain terminal configured to provide the second control current for control of the CCO 101. In this embodiment, the CCO 101 is connected between the drain terminal of the second transistor 102 and the reference terminal 107, however in other embodiments the CCO 101 may be connected between the drain terminal of the second transistor 102 and the voltage supply terminal 103, wherein the source terminal of the second transistor 102 is instead connected to the reference terminal 107. It will be understood that one or more other suitable adjustments may be made to the PLL circuit 100 in order to accommodate the CCO 101 being connected to the voltage supply terminal 103 in these other embodiments.

In this embodiment, the source terminal of the second transistor 102 is also coupled to a first terminal of a fourth capacitor 104, and the gate terminal of the second transistor 102 is also coupled to a second terminal of the fourth capacitor 104. Thus, the fourth capacitor is coupled in parallel with the source terminal and the gate terminal of the second transistor 102, and the second error signal INT_{dn}, INTᵤₚ is integrated on the fourth capacitor 104. This integrated error signal is used to control the output currents provided by the second transistor 102 and the third transistor 105.

In this embodiment, the time-to-voltage circuit 120 is configured to be coupled to the voltage source 103 by way of a third transistor 105 having a source terminal configured to be coupled to the voltage source 103, a gate terminal configured to receive the control signal based on the second error signal INT_{dn}, INTᵤₚ and a drain terminal configured to provide the supply current to the first capacitor 121. In this embodiment, the time-to-voltage circuit 120 also includes a demultiplexer 126 configured to provide the supply current either to the first capacitor 121, or to a reference voltage terminal 124 (e.g. ground). The demultiplexer 126 is controlled by the first error signal PROP_{dn}, such that when the first error signal PROP_{dn} is low, charge from the voltage source 103 is directed through the third transistor 105 and the demultiplexer 126 to the reference voltage terminal 124. When the first error signal PROP_{dn} is high, charge from the voltage source 103 is directed through the third transistor 105 and the demultiplexer 126 to the first capacitor 121. The source terminal of the third transistor 105 is also coupled to the first terminal of the fourth capacitor 104, and the gate terminal of the second transistor 102 is also coupled to the second terminal of the fourth capacitor 104. This arrangement is advantageous because the fourth capacitor 104 acts as an integrator to integrate the second error signal INTᵤₚ, INT_{dn} into an approximately constant voltage that subsequently controls the currents provided by the second transistor 102 and the third transistor 105. Using this voltage to control the second transistor 102 current (and therefore the CCO current), automatically generates the correct bias current for the CCO 101. By having the third transistor 105 generating a relative current to this CCO current for the time-to-voltage circuit 120, makes the bandwidth of the PLL circuit 100 independent of the CCO 101 bias condition (and therefore independent of PVT). In some other embodiments, a constant current is provided to the fourth capacitor 104 and / or a bias current is used to provide the supply current to the first capacitor 121.

In the embodiment shown in Figure 1, the apparatus also includes a controller 106 configured to delay the provision of the second feedback signal FB_{INT} to the second, integrating part 112 relative to the provision of the first feedback signal FB_{PROP} to the first, proportional part 111. The delay may be based on a predetermined number of oscillations of the oscillating output signal Fcco or it may be any other suitable time period.

We will now describe the operation of the apparatus 100 and the signal generated by the controller 106. The frequency dividing (or multiplying) applied to generate the feedback signals may be applied by circuitry of the controller 106. Accordingly, the box labelled as the controller 106 may be considered to be a controller and frequency divider, although it is referred to herein as a controller for brevity.

In some embodiments, such as the one shown in Figure 1, the controller 106 may be configured to generate a reset signal to short the first capacitor 121 prior to the controller 106 being configured to generate a sample signal. In this embodiment it is achieved by closing a reset switch 123 which connects the first capacitor to the reference voltage terminal 124. The sample signal comprises an instruction to sample the error signal, wherein the first charge pump circuit, based on receipt of the sample signal, is configured to sample the first error signal PROP_{dn} during the first part of the reference period, as will be discussed below. In this embodiment, the sample signal is used to close a sample switch 125 to connect the second capacitor 122 to the first capacitor 121, thereby transferring the voltage over the first capacitor 122 onto the second capacitor 122.

Following this, during a pulse of the first error signal PROP_{dn}, the voltage source 103 is connected to the first capacitor 121, and therefore the voltage of the first capacitor 121 rises, starting from the reference voltage. As previously mentioned, the first error signal PROP_{dn} is based on the difference between the reference signal F_{ref} and the first feedback signal FB_{PROP} which is based on the oscillating output signal F_{CCO}. In this embodiment, the pulse width of the first error signal PROP_{dn} is representative of this difference, and so the voltage over the first capacitor 121 at the termination of the first error signal PROP_{dn} is also representative of this difference. In other embodiments some other suitable characteristic of the first error signal PROP_{dn} may be representative of the difference between the reference signal F_{ref} and the first feedback signal FB_{PROP} which itself is based on the oscillating output signal F_{CCO}.

After the termination of the first error signal PROP_{dn} pulse, the voltage over the first capacitor 121 may be transferred onto the second capacitor 122 by closing the sample switch 125, thereby sampling the first error signal PROP_{dn}. The sample signal may remain high for the remainder of the reference period, until the first capacitor 121 is reset again by closing the reset switch 123. In this way, the sampled voltage over the second capacitor 122 can remain in a steady state until the first error signal PROP_{dn} is sampled again, thus providing an evenly large current during the entire reference period.

In this embodiment, the input signal to the CCO 101 is based on the first control current minus the second control current. It will be understood that the input signal to the CCO 101 could also be based on the first control circuit plus the second control current, or the second control circuit minus the first control circuit, upon making the relevant adjustments to the circuit topology. For example, the second control current can instead be provided to the CCO 101 in parallel to the second transistor 102, thereby contributing a small part of the current to the CCO 101. This alternative embodiment may provide reduced power consumption.

In this embodiment, the proportional action and therefore the bandwidth of the PLL circuit 100 is defined by a scaled version of the first control current to the CCO 101 (by way of the third transistor 105) and the ratio between C_{sc} and Cₚ. Therefore, the PLL circuit 100 is first order independent of PVT.

In some embodiments, one or more additional charge pumps could be used. The additional charge pumps may be similar to the charge pump of Figure 1, or they may have different offsets and / or internal gains. The additional charge pumps may extend the time error that can be measured and followed by a control action, for example.

In some embodiments, the PLL circuit 100 may also include an additional capacitor 160 connected in parallel between the first terminal of the impedance circuit 133, 134, 135 and the second terminal of the impedance circuit 133, 134, 135.

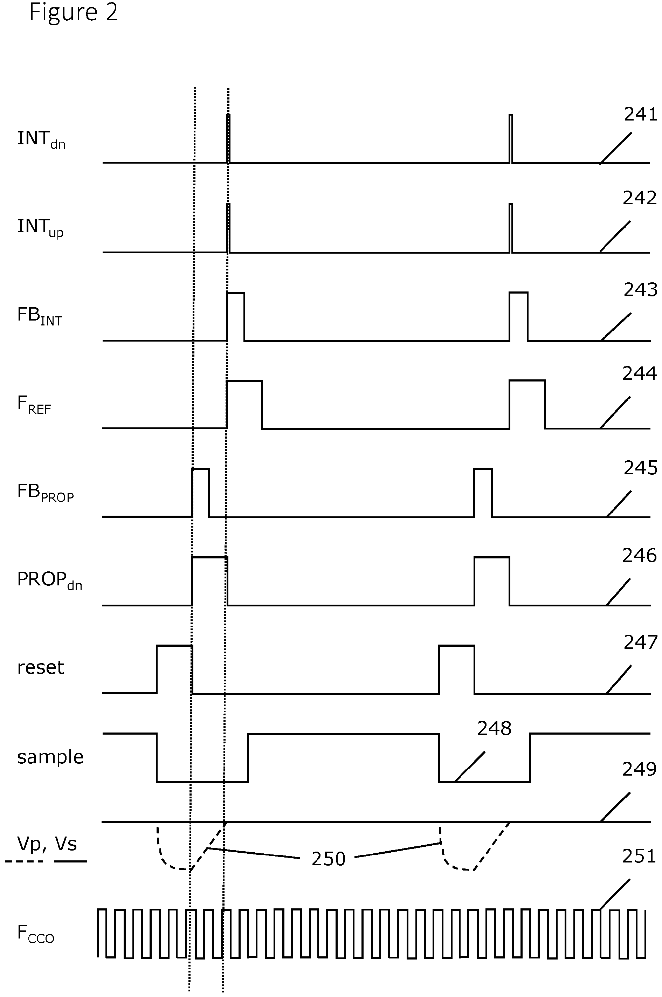

The operation of the embodiment shown in Figure 1 throughout a single reference period will now be explained with reference to Figure 1 and Figure 2.

Figure 2 shows an example signal diagram representing a number of signals within the circuit, according to an embodiment of the invention. In this embodiment, the reference voltage terminal 124 is ground (zero Volts). In this example, a deliberate constant offset is generated between F_{ref} 244 and FB_{PROP} 245 to generate a PROP_{dn} 246 pulse which is always larger than zero, and which has control in both directions for the proportional current. In other examples, the offset can additionally or alternatively be created by adding a constant current to the fourth capacitor 104. Deliberately creating an offset not only simplifies the circuit, it can also provide for the linearization (by only creating either up or down pulses, rather than both up and down pulses) of a fractional PLL without creating any reference breakthrough spurs.

During an initial part of the reference period, as represented here, the controller 106 sends a high reset signal 247 to the reset switch 123, thereby closing the reset switch 123, in order to short the first capacitor 121, thereby setting the voltage Vp 250 over the first capacitor 121 to zero Volts. At the same time, the controller 106 sends a low sample signal 248 to the sample switch 125, thereby opening the sample switch 125 and disconnecting the second capacitor 122 from the first capacitor 121.

After the voltage Vp 250 over the first capacitor 121 is zero Volts, the controller sets the reset signal 247 low, which re-opens the reset switch 123 in the time-to-voltage circuit 120 such that the first capacitor 121 is no longer shorted. The termination of the reset pulse may be triggered by any suitable means, such as the passing of sufficient time to set the voltage over the first capacitor 121 to zero Volts, or whereupon the voltage over the first capacitor 121 is measured to be zero Volts.

Next, the first proportional part 111 of the phase frequency detector 110 generates a first error signal PROP_{dn} 246, and the first error signal PROP_{dn} 246 is supplied to the time-to-voltage circuit 120. In the steady state example described below with reference to Figure 2, the phase shift is generated by advancing FB_{PROP} 245 by two clock cycles (represented in Figure 2 by two cycles of the oscillating output signal F_{CCO} 251), compared to FB_{INT} 243. In this example, FB_{PROP} 245 is advanced by 2 clock cycles 251, although it will be appreciated that other advancement lengths are possible, including zero. In other examples, two versions of the reference signal F_{ref} 244 are provided which are delayed with reference to each other. In these examples, the same feedback signal may be used for both phase frequency detectors. That is, FB_{INT} is the same as FB_{PROP}.

The rising edge of the reference signal F_{ref} 244 defines the falling edge of the first error signal PROP_{DN} 246, and as such, the pulse width of PROP_{DN} 246 is representative of the difference between the reference signal F_{ref} 244 and the first feedback signal FB_{PROP} 245.

The time-to-voltage circuit 120 uses the first error signal PROP_{dn} 246 to direct charge from the voltage source 103, through the third transistor 105 and the demultiplexer 126, into the first capacitor 121. While the first error signal PROP_{dn} 246 is high, the first capacitor 121 charges, such that when the first error signal PROP_{dn} 246 returns to low (i.e., after the termination of the first error signal PROP_{dn} 246 pulse) the voltage Vₚ 250 on the first capacitor 121 is representative of the difference between the between the reference signal F_{ref} 244 and the first feedback signal FB_{PROP} 245.

After the termination of the first error signal PROP_{dn} 246 pulse, the controller 106 sets the sample signal 248 to high which closes the switch 125 within the time-to-voltage circuit 120 which connects the second capacitor 122 to the first capacitor 121. As a result, the voltage Vₛ 249 on the second capacitor 122 becomes equal to (or, in other examples, is based on) the voltage Vₚ 250 on the first capacitor 121. Therefore, the voltage Vₛ 249 on the second capacitor 122 is representative of the difference between the between the reference signal F_{ref} 244 and the first feedback signal FB_{PROP} 245. The voltage Vₛ 249 on the second capacitor 122 may be referred to as the voltage signal and is supplied to the voltage-to-current circuit 130. In this embodiment, the sample signal 248 remains high until the beginning of the next reference period, which is initiated by the reset signal 247, but in other embodiments, the sample signal 248 may remain high for only long enough to supply the voltage signal to the voltage-to-current circuit 130.

Meanwhile, the reference signal F_{ref} 244 and the second feedback signal FB_{INT} 243 are provided to the second integrating part 112, after the two clock cycles have passed. It will be appreciated that in other embodiments, two versions of the reference signal F_{ref} 244 may be provided (one for each part of the phase frequency detector 110).

The second integrating part 112 of the phase frequency detector 110 generates a second error signal having components INT_{dn} 241 and INTᵤₚ 242 based on an integration of the difference between the reference signal F_{ref} 244 and a second feedback signal, FB_{INT} 243. The second integrating part 112 of the phase frequency detector 110 provides the second error signal INT_{dn} 241, INTᵤₚ 242 to the gate of the second transistor 102 which, along with the fourth capacitor 104, controls the source voltage from the voltage source 103 to provide the first control current.

The voltage-to-current circuit 130 uses the voltage follower 131, 132 and the third capacitor 133 to convert the voltage signal into the second control current, which is subtracted from the first control current by the circuit topology. The resulting current is supplied to the CCO 101 which generates the oscillating output signal F_{CCO} 251 which tracks the reference signal F_{ref} 244.

The CCO 101 provides the oscillating output signal F_{CCO} 251 to the controller 106 which may control the oscillation switches 134, 135 used to oscillate the connection of the third capacitor 133. The controller 106 generates the first and second feedback signals FB_{PROP} 245, FB_{INT} 243 to be used within the subsequent reference period.

In some embodiments, the PLL circuit 100 also includes an additional conventional proportional charge pump (not shown), configured to supply a third control current to the CCO 101. In these embodiments, the third control current is constant. As a result, the input error range for the phase frequency detector is increased.

The PLL circuit 100 may be implemented into a radio transceiver, a computer, a vehicle, an inverter, or any other suitable electronic device.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
a phase locked loop circuit including:
an input configured to receive an oscillating reference signal, F_{ref}, having a reference period;
a current controlled oscillator, CCO, configured to generate an oscillating output signal, based on an input signal;
an error detector configured to generate one or more error signals based on a phase difference between the reference signal and at least one of one or more feedback signals, wherein the one or more feedback signals are based on the oscillating output signal F_{CCO}; and
a charge pump circuit configured to receive at least a first of the one or more error signals, determine a voltage indicative of a duration of the first error signal during a first part of the reference period, and provide a control current to the CCO for at least a remaining part of the reference period, wherein the control current comprises at least part of the input signal to the CCO and is based on the determined voltage.

2. The apparatus of claim 1, wherein the error detector is a phase frequency detector comprising:
a first, proportional part configured to generate the first error signal of the one or more error signals based on the difference between the reference signal, and a first feedback signal of the one or more feedback signals that is based on the oscillating output signal; and
a second, integrating part configured to generate a second error signal of the one or more error signals based on an integration of the difference between the reference signal and a second feedback signal of the one or more feedback signals that is based on the oscillating output signal.

3. The apparatus of claim 2, wherein the charge pump circuit comprises a first charge pump circuit and the control current comprises a first control current and thereby the first charge pump circuit is configured to receive the first error signal, determine the voltage indicative of the duration of the first error signal during the first part of the reference period, and provide the first control current to the CCO comprising at least part of the input signal based on the determined voltage for at least the remaining part of the reference period; and
wherein the charge pump circuit further includes:
a second charge pump circuit configured to generate a control signal based on the second error signal; and
a current source configured to generate a second control current based on the control signal;
wherein the input signal to the CCO is based on the first control current and the second control current.

4. The apparatus of any preceding claim, wherein the charge pump circuit comprises:
a time-to-voltage circuit configured to convert at least one of the one or more error signals representing the phase difference between the reference signal and the one or more feedback signals to a voltage signal; and
a voltage-to-current circuit configured to receive the voltage signal from the time-to-voltage circuit and convert it to the control current.

5. The apparatus of claim 3, wherein the first charge pump circuit comprises:
a time-to-voltage circuit configured to convert the first error signal to a voltage signal; and a voltage-to-current circuit configured to receive the voltage signal from the time-to-voltage circuit and convert it to the control current;
wherein:
the time-to-voltage circuit includes a first capacitor and the time-to-voltage circuit is configured such that the first capacitor is charged by a current induced by a source voltage while the first error signal is provided to the time-to-voltage circuit;
the time-to-voltage circuit includes a second capacitor and wherein said charge pump circuit is configured to sample the error signal during the first part of the reference period by the time-to-voltage circuit being configured to couple the first capacitor to the second capacitor such that that the second capacitor is charged by the first capacitor and a voltage over the second capacitor defines the voltage signal;
the voltage-to-current circuit comprises a voltage follower configured to receive the voltage signal from the second capacitor and, based on the voltage signal, control a voltage applied to an impedance circuit,
the impedance circuit comprises a switched capacitor circuit comprising a third capacitor that is switched at the frequency of the oscillating output signal, and
the control current is based on a voltage over the impedance circuit.

6. The apparatus of claim 5, wherein the first capacitor and the third capacitor are of the same type, and the ratio of the capacitance between the first capacitor and the third capacitor is programmable.

7. The apparatus of claim 5 or claim 6, wherein the voltage follower comprises a first amplifier and a first transistor, wherein
an output of the first amplifier is coupled to a gate of the first transistor,
a non-inverting input of the first amplifier is coupled to the second capacitor,
an inverting input of the first amplifier is coupled to a source terminal of the first transistor,
the source terminal of the first transistor is coupled to a first terminal of the impedance circuit,
a second terminal of the impedance circuit is configured to be coupled to a reference voltage, and wherein
a drain terminal of the first transistor is coupled to receive part of the second control current.

8. The apparatus of claim 7, wherein the current source comprises a second transistor having a source terminal configured to be coupled to a voltage source, a gate terminal configured to receive the control signal based on the second error signal and a drain terminal configured to provide the second control current for control of the CCO;
wherein the source terminal of the second transistor is also coupled to a first terminal of a fourth capacitor, and the gate terminal of the second transistor is also coupled to a second terminal of the fourth capacitor; and
wherein the time-to-voltage circuit is configured to be coupled to the voltage source via a third transistor having a source terminal configured to be coupled to the voltage source, a gate terminal configured to receive the control signal based on the second error signal and a drain terminal configured to provide a supply current to the first capacitor,
wherein the source terminal of the third transistor is also coupled to the first terminal of the fourth capacitor, and the gate terminal of the second transistor is also coupled to the second terminal of the fourth capacitor.

9. The apparatus of claim 2, further including a controller configured to advance the provision of the first feedback signal to the first, proportional part relative to the provision of the second feedback signal to the second, integrating part.

10. The apparatus of claim 9, wherein the advancement is based on a predetermined number of oscillations of the oscillating output signal.

11. The apparatus of claim 5, further including a controller configured to generate a reset signal to short the first capacitor prior to the controller being configured to generate a sample signal, wherein the first charge pump circuit, based on receipt of the sample signal, is configured to sample the determined voltage during the first part of the reference period.

12. The apparatus of claim 8, wherein the apparatus is configured to provide a constant current to the time-to-voltage circuit.

13. The apparatus of claim 3, wherein the input signal to the CCO is based on the second control current minus the first control current.

14. The apparatus of any preceding claim, further comprising an additional proportional charge pump, configured to supply a third control current to the CCO.

15. An electronic device comprising the apparatus of any preceding claim.
